# EUROPEAN PATENT APPLICATION

(11) **EP 2 040 529 A1**
(43) Date of publication of application: **25.03.2009**
(21) Application number: 07768263.1
(22) Date of filing: 29.06.2007
(51) Int. Cl.: H05K 9/00, G09F 9/00

(54) **ELECTROMAGNETIC WAVE SHIELDING MESH**

(30) Priority: 30.06.2006 JP 2006180722
(71) Applicant: Seiren Co., Ltd, Fukui-shi, Fukui 918-8003 (JP)
(72) Inventor: TAKAHASHI, Toshiyuki, Fukui-shi, Fukui 918-8003 (JP)
(74) Representative: Hamer, Christopher K.
(86) International application number: PCT/JP2007/063530
(87) International publication number: WO 2008/001958

(57) **Abstract**

Provided is an electromagnetic wave shielding mesh, which is arranged on the front face of a display such as a PDP (Plasma Display Panel) or an FED (Field Emission Display) thereby to shield the leakage of electromagnetic waves. The electromagnetic wave shielding mesh has excellent light transmitting and electromagnetic wave shielding properties, but has neither moire nor brightness mottle in a manner to match the display having various pixel pitches. The electromagnetic wave shielding mesh is **characterized in that** it is woven of fibrous filaments and has a metallic cover film formed on its surface to give an electric conductivity, and in that its ratio (R) of a weft density to a warp density is 0.67 ≤ R ≤ 0.97, or 1.03 ≤ R ≤ 1.50.

## Description

### Field of the Invention

The present invention relates to an electromagnetic wave-shielding mesh having good light permeability and electric conductivity, the mesh being placed on the front face of a display such as PDP (Plasma Display Panel) or FED (Field Emission Display) thereby to shield the leakage of electromagnetic waves.

### Background of the Invention

Recently, electromagnetic waves leaked from electronic devices cause various problems such as malfunctions of other electronic devices, communication troubles or the like. It is also necessary in large-sized display products such as PDP (Plasma Display Panel) to shield electromagnetic waves leaked from the display panels. In order to shield electromagnetic waves from the large-scaled display panels such as PDP, electromagnetic wave-shielding materials used therefor are required to have sufficient light permeability not to affect bad influence to a display picture quality.

As these materials, transparent electrically conductive membranes such as ITO membrane (indium-tin oxide membrane), etched mesh films obtained by etching a film having a copper layer in a mesh form and electrically conductive fiber meshes obtained by forming a film layer on each fiber yarn of a fiber yarn mesh have been already proposed.

The ITO membrane has higher light permeability but the electric conductivity is low and thus the electromagnetic wave-shielding effect is insufficient. The etched mesh film and electrically conductive fiber mesh have each high electric conductivity and are sufficient electromagnetic wave-shielding effects, but have such a problem that the mesh structures may cause so-called "moire" on the display due to interference with display picture elements.

JP 2005-150427A discloses a method and program for designing the mesh structure pattern of an etched mesh film or the like by using a computer in order to improve such a moire problem.

In this method, a group of proximate rectangles constituting the mesh structure is formed by shifting each rectangle up and down and right and left in parallel by using random numbers and/or changing the length of each side of each rectangle by using random numbers.

When designing a mesh structure by using this method, however, it is necessary to confirm the picture element pitches of a PDP display in advance and there is a problem that whether or not the mesh structure pattern designed by a computer calculation can actually prevent a moire can not be confirmed until after an electromagnetic wave-shielding material having the designed pattern has been actually manufactured and evaluated.

JP 11-121978A discloses an electromagnetic wave-shielding plate obtained by forming a mesh-like electrically conductive pattern on a transparent base plate and the line pitches of mesh-like electrically conductive lines which constitute the electrically conductive pattern are changed in turn. In such a case, however, a wide pitch portion and a narrow pitch portion are necessarily different in opening size or opening ratio and this may cause opening spots. When such an electromagnetic wave-shielding plate is placed on the front of a display, spots may be produced in the picture brightness.

### Disclosure of the Invention

### Objects of the Invention

The object of the present invention is to provide an electromagnetic wave-shielding mesh which is placed on the front face of a display such as PDP (Plasma Display Panel) or FED (Field Emission Display) thereby to shield the leakage of electromagnetic waves and which has superior light permeability and electromagnetic wave-shielding effects and can be applied to displays having various picture element pitches without causing any moire and brightness spot.

### Summary of the Invention

The present inventor have earnestly investigated so as to solve the above problems and found that when an electromagnetic wave-shielding mesh in which the warp yarn density are different from the weft yarn density in a specific range is placed on the front face of a display, the leakage of electromagnetic waves can be sufficiently shielded without causing any moire and brightness spot.

The present invention resides in an electromagnetic wave-shielding mesh woven with fiber yarns and coated an electrically conductive metal onto each yarn, characterized in that the ratio R of weft yarn density to warp yarn density in the mesh is 0.67 ≤ R ≤ 0.97 or 1.03 ≤ R ≤ 1.50.

As a method for forming the metal coating, a conventional electroless plating method or both of the electroless plating method and a conventional electroplating method can be preferably used.

By subjecting the metal surface of the electromagnetic wave-shielding mesh to a black color treatment, the obtained mesh is less noticeable and improves the visibility of the display screen when it is placed on the front face of a PDP display.

### Effects of the Invention

The electromagnetic wave-shielding mesh of the present invention has superior light permeability and electromagnetic wave-shielding effects and is preferably used as an electromagnetic wave-shielding material which is placed on the front face of a display without causing any moire and brightness spot.

### Embodiments of the Invention

The mesh of the present invention is a woven mesh fabric composed of weft yarns and warp yarns. Such a mesh has a wide interval between adjacent yarns and thus has good light permeability.

Such a yarn interval in a mesh is often expressed by an opening ratio which is a ratio of the area of portions existing no yarn to a unit area of the mesh and is calculated from weft yarn density, warf yarn density, weft yarn diameter and warf yarn diameter. In the present invention, the opening ratio of the mesh is preferably within the range of 50% to 90%. If the opening ratio is lower than 50%, light is not sufficiently transmitted therethrough and when the mesh is placed on the front face of a display such as PDP, the screen tends to be darkened and if the opening ratio is higher than 90%, not only the processability but also the electromagnetic wave-shielding effects tend to be lowered.

The yarn constituting the mesh is not specially limited but a filament yarn is preferred. Monofilament and multifilament yarns are both preferably used.

Any fiber materials may be used as far as filament yarns can be produced therefrom. Such fiber materials include synthetic fibers, semisynthetic fibers, regenerated fibers, inorganic fibers, metal fibers and the like. Among them, synthetic fibers are preferable in view of processability and durability. Examples of the synthetic fiber include polyester fibers such as polyethylene terephthalate and polybutylene terephthalate, polyamide fibers such as nylon 6 and nylon 66, polyolefin fibers such as polyethylene and polypropylene, polyacrylonitrile fibers, polyvinyl alcohol fibers, polyurethane fibers, polyvinyl chloride fibers and combinations thereof. Among them, polyester fibers and polyamide fibers are more preferable.

The diameter of the filament yarn is preferably 20-50µm. The warp yarn density and weft yarn density are both preferably 50-200 yarns/inch, provided that the warp density is essentially different from the weft density, more concretely, the ratio R of weft density to warp density is 0.67 ≤ R ≤ 0.97 or 1.03 ≤ R ≤ 1.50.

If the diameter of the filament yarn is less than 20µm, the weaving tends to become difficult and the processability tends to be lowered. If the diameter is more than 50µm, the light permeability tends to be lowered. More preferable diameter is 24-40µm.

If the yarn density is less than 50 yarns/inch, the electromagnetic wave-shielding effects tend to be lowered. If the yarn density is more than 200 yarns/inch, the light is not sufficiently transmitted through the mesh, and when the mesh is placed on the front face of a display, the screen tends to be darkened. More preferable yarn density is 70-150 yarns/inch.

The fabric structure of the mesh of the present invention is not specially limited as far as the mesh is a woven mesh fabric. Plain weave mesh fabric, twill weave mesh fabric and stain weave mesh fabric are preferably exemplified.

Among them, plain weave mesh fabric is more preferred because the plain weave mesh fabric has warps and wefts crossed each another and the respective crossed points are constrained sufficiently and thus the mesh has good shape-stability and is easy to handle.

In the weaving, the warp density can be controlled depending on reeds in a weaving machine and the weft density can be controlled by the winding-up speed of a woven mesh. By setting them suitably, a mesh having predetermined yarn densities can be woven easily. The yarn densities can be somewhat adjusted in a later processing.

In the present invention, in the case where the fiber yarn mesh is not a metal fiber yarn mesh, electric conductivity is provided to the fiber yarn mesh. A preferable electric conductivity-providing method is a method for forming a metal coating on each surface of fiber yarns constructing the mesh. Metal coating may be produced by various conventional methods such as vapor deposition method, sputtering method, electroplating method, electroless plating method and the like.

Among them, electroless plating method and combination of electroless plating method and electroplating method are preferable in view of uniformity of metal coating and processability.

Metals to be used for forming the metal coating and metals of metal fibers are not specially limited as far as they have electric conductivity. Examples include gold, silver, copper, nickel and chromium. Among them, however, copper is more preferable in view of cost, processability and electric conductivity.

It is also possible that another one or more different coatings are applied onto each metal coated fiber yarn of the electrically conductive mesh thus obtained.

For example, a resin coating can be applied in order to protect the metal coating. Also, a different metal coating can be further applied.

A black color treatment in order to make the color of the surface a black color is preferable. Such a black color treatment includes a surface oxidation treatment, sulfide treatment, painting and plating by using various metals. By such a black color treatment, the mesh becomes less noticeable and the visibility of a PDP display can be improved.

As mentioned above, by forming a metal coating on each fiber yarn constituting the mesh, electric conductivity is provided to the mesh. It is necessary that the mesh is constituted by fiber yarns having different yarn densities between warps and wefts. By changing the warp yarn density from the weft yarn density, when the mesh is placed on the front face of a display such as PDP as an electromagnetic wave-shielding material, any moire is not generated.

Concretely, it is necessary that the ratio R of weft yarn density to warp yarn density is 0.67 ≤ R ≤ 0.97 or 1.03 ≤ R ≤ 1.50. R means weft yarn density/warp yarn density.

If a mesh having a ratio of weft yarn density to warp yarn density of 0.97 < R < 1.03 is placed on the front face of PDP display having various picture element pitches, the generation of moire can not be prevented.

Also, a mesh having a ratio of weft yarn density to warp yarn density of less than 0.67 or more than 1.50 has bad shape-stability and is difficult to handle.

When placing the electromagnetic wave-shielding mesh on the front face of a display such as PDP, the mesh can be positioned at an angle to the front face or bias in order to reduce moires. The angle can be appropriately adjusted with the picture element pitched of the PDP.

### Examples

The present invention will be described below by way of Examples, but the invention is not limited to Examples.

In the following Examples, the evaluation of "moire" was conducted by placing the produced electromagnetic wave-shielding mesh at an angle or bias onto the front face of a PDP display, lighting only green color of the PDP display in a dark room, and evaluating the presence of "moire" by visual observation at a distance of 3.0 meters from the PDP display. The results are shown in Table 1. In the evaluation, the following two commercially available PDP displays having each the following picture element pitch were used:
PDP display A: The picture element pitches are 809.89µm (vertical) and 269.88µm (horizontal).
PDP display B: The picture element pitches are 698.00µm (vertical) and 310.00µm (horizontal).

### Example 1:

A mesh having a warp yarn density of 132 yarns/inch and a weft yarn density of 127 yarns/inch was woven by using polyester monofilaments having a diameter of 27µm. The ratio R of weft yarn density to warp yarn density was 0.96. The mesh was subjected to a conventional electroless cooper plating and then to conventional eletroless nickel zinc plating as a black color treatment to obtain an electromagnetic wave-shielding mesh. The opening ratio of the obtained electromagnetic wave-shielding mesh was 72.6%.

As the result of the evaluations using the PDP displays, it was found that in the cases where PDP display A was used, when the bias angle was 20.5-22.0° and in the case where PDP display B was used, when the bias angle was 18.5-21.5°, any moire did not appear on the displays.

### Example 2:

A mesh having a warp yarn density of 132 yarns/inch and a weft yarn density of 115 yarns/inch was woven by using polyester monofilaments having a diameter of 27µm. The ratio R of weft yarn density to warp yarn density was 0.87. The mesh was subjected to a conventional electroless copper plating and then to a conventional electroless nickel zinc plating as a black color treatment to obtain an electromagnetic wave-shielding mesh. The opening ratio of the obtained electromagnetic wave-shielding mesh was 73.8%.

As the result of the evaluations using the PDP displays, it was found that in the case where PDP display A was used, when the bias angle was 20.5-22.0°, and in the case where PDP display B was used, when the bias angle was 20.5-24.5°, any moire did not appear on the displays.

### Example 3:

A mesh having a warp yarn density of 127 yarns/inch and a weft yarn density of 132 yarns/inch was woven by using polyester monofilaments having a diameter of 27µm. The ratio R of weft yarn density to warp yarn density was 1.04. The mesh was subjected to a conventional electroless copper plating and then to a conventional electroless nickel zinc plating as a black color treatment to obtain an electromagnetic wave-shielding mesh. The opening ratio of the obtained electromagnetic wave-shielding mesh was 72.6%.

As the result of the evaluations using the PDP displays, it was found that in the case where PDP display A was used, when the bias angle was 68.0-59.5°, and in the case where PDP display B was used, when the bias angle was 68.5-71.5°, any moire did not appear on the displays.

### Example 4:

A mesh yarn having a warp yarn density of 115 yarns/inch and a weft yarn density of 132 yarns/inch was woven by using polyester monofilaments having a diameter of 27µm. The ratio R of weft yarn density to warp yarn density was 1.15°. The mesh was subj ected to a conventional electric nickel plating and then to a conventional electroless nickel zinc plating as a black color treatment to obtain an electromagnetic wave-shielding mesh. The opening ratio of the obtained electromagnetic wave-shielding mesh was 73.8%.

As the result of the evaluations using the PDP displays, it was found that in the case where PDP display A was used, when the bias angle was 68.0-69.5°, and in the case where PDP display B was used, when the bias angle was 65.5-69.5°, any moire did not appear on the displays.

### Comparative Example 1:

A mesh having a warp yarn density of 132 yarns/inch and a weft yarn density of 132 yarns/inch was woven by using polyester monofilaments having a diameter of 27µm. The ratio R of weft yarn density to warp yarn density was 1.00. The mesh was subjected to a conventional electroless copper plating and then to a conventional electroless nickel zinc plating as a black color treatment to obtain an electromagnetic wave-shielding mesh. The opening ratio of the obtained electromagnetic wave-shielding mesh was 72.1%.

As the result of the evaluation using the PDP displays, it was found that in the case where PDP display A was used, even when the bias angle was adjusted to any angles, moire appeared and did not disappear at any bias angles. In the case where PDP display B was used, when the bias angle was 18.5-19.5°, moires were weaken but did not disappear even at the above angles.

### Comparative Example 2:

A mesh having a warp yarn density of 126 yarns/inch and a weft yarn density of 128 yarns/inch was woven by using polyester monofilaments having a diameter of 27µm. the ratio R of weft yarn density to warp density was 1.02. The mesh was subjected to a conventional electroless copper plating and then to a conventional electroless nickel zinc plating as a black color treatment to obtain an electromagnetic wave-shielding mesh. The opening ratio of the obtained electromagnetic wave-shielding mesh was 73.1%.

As the result of the evaluations using the PDP displays, it was found that in both cases where PDP displays A and B were used, even when the bias angle was adjusted to any angles, moire appeared and did not disappear.

**Table 1**

| | warp density (yarns/inch) | Weft density (yarns/inch) | Yarn density ratio R | Opening ratio(%) | PDP display | Optimum bias degree(°) | Moire evaluation |
|---|---|---|---|---|---|---|---|
| Ex. 1 | | | | | A | 20.5-22 | ○ |
| | 132 | 127 | 0.96 | 72.6 | B | 18.5-21.5 | ○ |
| Ex. 2 | | | | | A | 20.5-22 | ○ |
| | 132 | 115 | 0.87 | 73.8 | B | 20.5-24.5 | ○ |
| Ex. 3 | | | | | A | 68-69.5 | ○ |
| | 127 | 132 | 1.04 | 72.6 | B | 68.5-71.5 | ○ |
| Ex. 4 | | | | | A | 68-69.5 | ○ |
| | 115 | 132 | 1.15 | 73.8 | B | 65.5-69.5 | ○ |
| Com. Ex. 1 | | | | | A | - | × |
| | 132 | 132 | 1.00 | 72.1 | B | 18.5-19.5 | △ |
| Com. Ex. 2 | | | | | A | - | × |
| | 126 | 128 | 1.02 | 73.1 | B | - | × |

| | | | | | | | |
|---|---|---|---|---|---|---|---|
| Note) ○ indicates "excellent" △ indicates "fair" × indicates "poor" | | | | | | | |

## Claims

1. An electromagnetic wave-shielding mesh woven with fiber yarns and coated an electrically conductive metal onto each yarn, **characterized in that** the ratio R of weft yarn density to warp yarn density is 0.67 ≤ R ≤ 0.97 or 1.03 ≤ R ≤ 1.50.

2. The electromagnetic wave-shielding mesh as set forth in Claim 1, wherein the metal coating is formed by an electroless plating method or both of an electroless plating method and an electroplating method.

3. The electromagnetic wave-shielding mesh as set forth in Claim 1 or 2, wherein the surface of the metal coating is subjected to a black color treatment.

4. The electromagnetic wave-shielding mesh as set forth in any one of Claims 1-3, wherein the opening ratio of the mesh is 50-90%.

5. The electromagnetic wave-shielding mesh as set forth in any one of Claims 1-4, wherein the fiber yarn is monofilament yarn or multifilament yarn.

6. The electromagnetic wave-shielding mesh as set forth in any one of Claims 1-5, wherein the fiber is synthetic fiber.

7. The electromagnetic wave-shielding mesh as set forth in Claim 6, wherein the synthetic fiber is polyester or polyamide fiber.

8. The electromagnetic wave-shielding mesh as set forth in any one of Claims 1-7, wherein the diameter of the fiber yarn is 20-50µm.
